# EUROPEAN PATENT APPLICATION

(11) **EP 4 273 541 A1**
(43) Date of publication of application: **08.11.2023**
(21) Application number: 22171060.1
(22) Date of filing: 01.05.2022
(51) Int. Cl.: G01N 30/56, B01D 15/22, G01N 30/60

(54) **MICROFLUIDIC DEVICE**

(71) Applicant: Vrije Universiteit Brussel, 1050 Brussel (BE)
(72) Inventor: DESMET, Gert, 1982 Elewijt (BE); VANKEERBERGEN, Bert, 1050 Brussel (BE); VERLOY, Sandrien, 1050 Brussel (BE); JIMIDAR, Ignaas S.M., 7511 GH Enschede (NL)
(74) Representative: Winger

(57) **Abstract**

A microfluidic device (1) comprising: a fluidic inlet (14) and a fluidic outlet (16), and a plurality of interconnected fluidic channels (31, 32), fluidically coupling the fluidic inlet (14) to the fluidic outlet (16), wherein a net nominal flow direction (4) of each of the plurality of interconnected fluidic channels (31, 32) is substantially parallel, wherein the fluidic channels (31, 32) comprise a plurality of stationary phase particles (2), characterized in that, within each fluidic channel (31, 32), neighbouring particles (2), along a local flow direction, are separated from each other by a mean distance that is at most half of a mean diameter of the particles (2).

## Description

### Technical field of the invention

The present invention relates to the field of microfluidic devices. In particular, the present invention relates to a microfluidic device and a chromatography device comprising the microfluidic device, and to a method for forming the microfluidic device.

### Background of the invention

High-performance liquid chromatography (HPLC) columns are widely used in chemical analysis. Conventionally, these columns are packed with spherical stationary phase particles. It is known in the art of chromatography that the performance (measured in terms on number of theoretical plates per meter) of these HPLC columns is compromised by the random nature of the packing of these particles.

Micro-pillar array columns provide HPLC columns with perfectly ordered networks. However, micro-pillar array columns are limited in the amount of retentive surface they can provide. Indeed, the retentive surface is typically provided by a thin shell at the pillar walls, where it is formed by electrochemical anodization. Furthermore, the silicon material of which these columns are typically made do not offer the same chemical versatility as the silica material most commercial HPLC spherical particles are made of. Therefore, the number and types of stationary phases available in micro-pillar array columns will likely be limited compared to the stationary phases available in the form of commercial HPLC spherical particles. The latter have furthermore been perfected over the past decades by several hundreds of different research groups and manufacturers. In addition, users are always reluctant to change the stationary phase they are using, as the elution times in their validated methods are usually linked to the use of one specific type of stationary phase.

There is hence a need for chromatographic columns wherein HPLC particles can be packed in a more ordered way than in the currently used randomly packed bed columns. WO2004046020A2 and WO2006097302A1 provide columns comprising highly ordered particles. However, these columns have a relatively low separative power per unit of fluid path length (or, equivalently, have a relatively low ratio of retention surface over column volume), so that their devices may have to be large compared to classic randomly packed bed columns to achieve a similar separative power.

In addition, there is a growing need in industry to use columns that, in the case of cylindrically shaped columns, have an inner diameter of only 0.5 mm to 1.0 mm. Such columns may have a relatively low solvent consumption, and may enhance the detection sensitivity compared to the currently widely commercially available columns having an inner diameter of 2.1 mm or 4.6 mm. However, there is a fundamental issue, recently revealed by GRITTI, Fabrice; WAHAB, M. Farooq. Understanding the science behind packing high-efficiency columns and capillaries: facts, fundamentals, challenges, and future directions. LC-GC North America, 2018, 36.2: 82-92, that prevents packing columns having an inner diameter of from 0.5 mm to 1 mm with a packing quality that is as good as that achieved for columns having an inner diameter of 2.1 mm or 4.6mm. Indeed, whereas in the latter, larger diameter columns, a minimal reduced plate height (which is a measure, well-known by the skilled person, for the ability to generate narrow analyte peaks) of 2 may be achieved, minimal plate heights in smaller diameter columns (having inner diameters of from 0.5 mm to 1 mm) are expected to be around 4 and more. It is an aim of the present invention to produce columns with a cross-section equal to or below that of a cylindrical column with an inner diameter of 1 mm, while offering plate heights that are as good or preferably significantly better than what can be achieved in 2.1 and 4.6mm columns.

There is, thus, still a need in the art for devices and methods that address at least some of the above problems.

### Summary of the invention

It is an object of the present invention to provide a good microfluidic device and chromatography device comprising the microfluidic device. It is a further object of the present invention to provide good methods and a good system for forming the microfluidic device.

The above objective is accomplished by a method and apparatus according to the present invention.

It is an advantage of embodiments of the present invention that a high stationary phase particle loading may be achieved. It is a further advantage of embodiments of the present invention that the separative power capacity per unit fluid path length may be large.

It is an advantage of embodiments of the present invention that a high level of ordering of stationary phase particles may be combined with a large throughput. It is a further advantage of embodiments of the present invention that a small plate height may be achieved.

In a first aspect, the present invention relates to a microfluidic device comprising a fluidic inlet and a fluidic outlet. The microfluidic device comprises a plurality of interconnected fluidic channels, e.g., flow paths, fluidically coupling the fluidic inlet to the fluidic outlet, wherein a net nominal flow direction of each of the plurality of interconnected fluidic channels is substantially parallel. Said net nominal flow direction of each of the plurality of interconnected fluidic channels is typically from the inlet to the outlet. Said net nominal flow direction of each of the plurality of interconnected fluidic channels typically overlaps with a net nominal flow direction of a fluid flowing through all fluidic channels combined, from the inlet to the outlet. The fluidic channels comprise a plurality of stationary phase particles. Within each fluidic channel, neighbouring particles, along a local flow direction, are separated from each other by a mean distance that is at most half of a mean diameter of the particles.

It is a advantage of embodiments of the present invention that neighbouring particles, neighbouring along the local flow direction, may be located close to each other, i.e., close-packed, so that a large concentration of particles in the fluidic channels may be achieved. In embodiments, a ratio of the volume of the particles over a volume of the channels is at least 0.2, for example at least 0.3, for example at least 0.6.

The plurality of interconnected fluidic channels may be considered to be a column segment of the microfluidic device. Said column segment may substitute chromatography columns of the state of the art. The fluidic inlet is typically an inlet, e.g., for a fluid of which components are to be separated by chromatography inside the column segment, to the plurality of fluidic channels. The fluidic outlet is typically an outlet, e.g., for the components of the fluid separated by said chromatography in the column segment, from the plurality of fluidic channels. The inlet and/or outlet may, for example, be a single inlet and/or outlet, respectively, for all fluidic channels, or may be one inlet and/or outlet, respectively, for each channel. In embodiments, the inlet, e.g., the microfluidic device inlet, is connected to the plurality of fluidic channels, e.g., to a first end of a, e.g., each, fluidic channel, via a first flow distributor. In embodiments, the outlet, e.g., the microfluidic device outlet, is connected to the plurality of fluidic channels, e.g., to a second end, different from the first end, of a, e.g., each, fluidic channel, via a second flow distributor. In preferred embodiments, a mean channel width of the first and/or second flow distributor is from 0.5 to 2.0, for example from 0.7 to 1.3, times a mean channel width of the plurality of fluidic channels. For example, the first flow distributor may comprise a bifurcating structure, e.g., bifurcating from the inlet, e.g., a single microfluidic device inlet, to the first end of each fluidic channel. For example, the second flow distributor may comprise a bifurcating structure, e.g., bifurcating from an outlet, e.g., a single microfluidic device outlet, to the second end of each fluidic channel.

In embodiments, the fluidic channels are meandering, for example, in a horizontal plane of the microfluidic device. In embodiments, a meander ratio, or sinuosity, of the fluidic channels, in a direction from the inlet to the outlet, or in a net nominal flow direction, is at least 1.5, for example at least 3, for example at least 10, for example at least 25. Herein, the meander ratio may be defined as a ratio from an inner length of the fluidic channel, along a flow path through the fluidic channel, e.g., through or along a center of the fluidic channel, to a length of the fluidic channel, in a direction from the inlet to the outlet, or in a net nominal flow direction, of the fluidic channel. In embodiments, each fluidic channel comprises at least 5, for example at least 10, for example at least 100, meanders. Herein, consecutive meanders, e.g., curves, e.g., bends, typically may have a curvature having an opposite sign. It is an advantage of these embodiments that a mean width of the fluidic channels may be small, while at the same time enabling the fluidic channels to be interconnected at a plurality of locations along the fluidic channel, so that pressure differences between parallel channels may be minimized.

In embodiments, a horizontal plane intersects each of the plurality of fluidic channels. For example, the fluidic channels may be formed by etching in a wafer, wherein a top surface of the wafer may be parallel with the horizontal plane. In these embodiments, adjacent channels may be located horizontally shifted with respect to each other. This is, however, not essential, and instead, at least some of the channels may be located at a different height with respect to each other, so that a horizontal plane does not intersect each of the fluidic channels. In embodiments, a mean width, e.g., a distance between opposing walls, perpendicular to the local flow direction and, preferably, in the horizontal plane, of each fluidic channel is from 1.0 to 50, for example from 1.0 to 10, for example from 1.1 to 10, for example from 1.1 to 5, for example from 1.3 to 5, times the mean diameter of the particles. In embodiments, the mean width is from 0.5 µm to 1000 µm, for example from 1 to 100 µm, for example from 5 µm to 50 µm. It is an advantage of these embodiments that the small mean width may result in good ordering of the particles inside the fluidic channels. As a result, a plate height that may be achieved with the microfluidic device may be low. In embodiments, the mean width is the mean over the complete length of a flow path through the fluidic channel, except, typically, where the fluidic path is fluidically connected to an adjacent fluidic path, where typically no opposite walls are present, that is, opposite along the direction of the width. In preferred embodiments, the fluidic channel is confined by walls, opposite in the width direction, along at least 50%, for example at least 70%, for example at least 90%, of the flow path length, e.g., through the center of the fluidic channel. In other words, the interconnections may interrupt the walls confining the fluidic channel over part of the length of the fluidic channel, but not over the complete length of the fluidic channel.

In embodiments, a mean height of each fluidic channel, perpendicular to the local flow direction, and perpendicular to the width, i.e., preferably, perpendicular to the horizontal plane, is at least 1.0, for example at least 1.1, for example at least 1.2, for example at least 10 times the mean diameter of the particles. In embodiments, the mean height of each fluidic channel is at most 5000, for example, at most 1000, such as at most 100, times the mean diameter of the particles. It is an advantage of these embodiments that the flow rate through the microfluidic device may be high.

In embodiments, the mean diameter of the stationary phase particles, e.g., porous HPLC particles, is from 0.1 µm to 20 µm, for example from 0.5 µm to 10 µm. In embodiments, a standard deviation on the mean diameter is at most 15%, for example at most 5%, for example at most 2.5%, of the mean diameter.

In embodiments, the stationary phase particles are formed of a mesoporous silica, a polymeric particle (e.g. synthetic or organic polymers) or any other suitable functional particle with good chromatographic properties. In embodiments, the stationary phase particles are beads, for example, having a substantially spherical shape, but the invention is not limited to the stationary phase particles having any shape. For example, instead, the shape may be cuboid or irregular.

In embodiments, the plurality of interconnected fluidic channels comprises at least 2, for example at least 10, for example at least 100, interconnected fluidic channels. It is an advantage of these embodiments that a small channel width, which may result in a small plate height, may be combined with a high throughput for the microfluidic device.

In embodiments, each fluidic channel comprises a plurality of fluidically coupled containers, wherein the containers have a mean width, e.g., a width, of from 1.0 to 4, for example from 1.1 to 3.5, times the mean diameter of the particles, and wherein a distance between the centers of adjacent containers is at most 1.5 times the width of the containers. In these embodiments, for example at least 50%, for example at least 70%, for example at least 90%, of the length, along a flow path, of the fluidic channel is formed of, e.g., consecutive, containers. The containers may have any shape, e.g., substantially cylindrically shaped or substantially rectangular cuboid or an irregular shape, but is preferably substantially cylindrically shaped.

In embodiments, the containers have a width of from 1.0 to 1.9, for example from 1.1 to 1.3, times the mean diameter of the particles. As such, the containers may contain only a single particle in the horizontal plane. In these embodiments, adjacent, e.g., consecutive, containers are preferably fluidically coupled through a coupling channel having a mean width smaller than 1.0, for example of from 0.3 to 0.7, times the mean particle diameter. It is an advantage of these embodiments that the particles are confined within their container. In different embodiments, the containers have a width of from 2.0 to 2.9, for example of from 2.1 to 2.4 times the mean diameter of the particles. As such, the containers may contain two particles in the horizontal plane. In these embodiments, adjacent, e.g., consecutive, containers are preferably fluidically coupled through a coupling channel having a mean width of from 0.3 to 1.4, times the mean particle diameter. In still different embodiments, the containers have a width of from 3.0 to 3.9, for example from 3.1 to 3.5, times the mean diameter of the particles. As such, the containers may contain three particles in the horizontal plane. In these embodiments, adjacent, e.g., consecutive, containers are preferably fluidically coupled through a coupling channel having a mean width of from 0.3 to 2.1, times the mean particle diameter. In even other embodiments, the width of and the coupling channel fluidically coupling the containers is scaled so the containers may contain four, five, six or more particles in the horizontal plane. It is an advantage of these embodiments that a high degree of ordering of the particles is enabled, while at the same time providing a high particle loading capacity, so that the separative power per unit fluid path length may be large. In preferred embodiments, the coupling channel has a length, in the local flow direction, that is at most 0.3 times the mean diameter of the particles.

In embodiments, each fluidic channel is interconnected to adjacent, parallel, fluidic channels at each meander of the fluidic channel. In some embodiments, for each couple of two adjacent fluidic channels, the two adjacent fluidic channels are interconnected with each other at every other meander, i.e., at one in two meanders. In embodiments, the fluidic channels are interconnected, e.g., each couple of adjacent fluidic channels is fluidically connected to each other, at a plurality of locations along the net nominal flow direction, wherein a distance, e.g., a mean distance, between subsequent locations in the net nominal flow direction is at most 5, for example at most 3, for example at most 2, for example at most 1, for example at most 0.5, and for example substantially 0 times a mean width of the fluidic channels. This interconnection may comprise a fluidic coupling between adjacent fluidic channels. For example, in embodiments wherein the fluidic channel is meandering, the fluidic channel may be connected to adjacent fluidic channels at each meander, e.g., loop, of the fluidic channel. These embodiments may enable that a similar pressure is present in each of the fluidic channels.

Any features of any embodiment of the first aspect may be independently as correspondingly described for any embodiment of any of the other aspects of the present invention.

In a second aspect, the present invention relates to a chromatography device, e.g., a HPLC device, comprising the microfluidic device according to any of the previous claims. In embodiments, the chromatography device comprises a fluidic pump configured for pumping a fluid from a fluid storage container, through the inlet, into the microfluidic device. In embodiments, the chromatography device comprises a detector for detecting the composition of fluid leaving the microfluidic device through the outlet of the microfluidic device, which may be any type detector as is well known to the skilled person. In embodiments, the chromatography device may comprise a computer comprising software for controlling the pump and/or the detector.

Any features of any embodiment of the second aspect may be independently as correspondingly described for any embodiment of any of the other aspects of the present invention.

In a third aspect, the present invention relates to a method for manufacturing the microfluidic device according to embodiments of the first aspect of the present invention, or for manufacturing the microfluidic device of the chromatography device according to embodiments of the second aspect of the present invention. The method comprises obtaining a substrate comprising the plurality of interconnected fluidic channels. The method further comprises filling the interconnected fluidic channels with a suspension comprising the plurality of stationary phase particles, dispersed in a fluid. Typically, the microfluidic device comprises an opening, e.g., an opened top or an opened side, through which the suspension is provided into the microfluidic channels. In these embodiments, the method may comprise a further step of closing the opening, e.g., with a lid. However, the invention is not limited thereto, and instead, for example, the fluidic inlet or the fluidic outlet may be used through which the suspension is provided into the microfluidic channels. It is an advantage of embodiments of the present invention that using a suspension, i.e., fluid filling, for filling the microfluidic channels with the stationary phase particles, may result in a high particle density in the channels.

In embodiments, obtaining the plurality of interconnected fluidic channels comprises obtaining the fluidic channels such that each fluidic channel has an opened top, wherein said filling comprises introducing the suspension into the fluidic channels from the top, preferably by rubbing using a patterned slab. The filling may be performed using wet rubbing using a profiled, i.e., patterned, polydimethylsiloxane (PDMS) substrate as patterned slab, or made of any other elastomeric material. The elastomeric material preferably has a low Young's modulus, e.g., a Young's modulus of at most 1500kPa, for example at most 1000 kPa at 25°C and 1atm. The elastomeric material preferably has a high failure strain, i.e., a strain before break. Preferably, the failure strain of the elastomeric material is at least 50%, for example at least 100%, for example at least 150%, at 25°C and 1atm. The inventors have unexpectedly found that wet rubbing the particles into the channels using a patterned slab formed of an elastomeric material, in particular when said elastomeric material is PDMS, may result in very good filling of the channels by the particles. In these embodiments, the method may further comprise a step of applying a lid for closing the top of the fluidic channels.

In embodiments, obtaining the plurality of interconnected meandering fluidic channels comprises obtaining the plurality of fluidic channels, such that a side of the plurality of fluidic channels is opened, wherein said filling comprises pumping the suspension, through the opened side, into each of the channels.

Any features of any embodiment of the third aspect may be independently as correspondingly described for any embodiment of any of the other aspects of the present invention.

In a fourth aspect, the present invention relates to a use of the microfluidic device according to embodiments of the first aspect of the present invention, for chromatography.

Any features of any embodiment of the fourth aspect may be independently as correspondingly described for any embodiment of any of the other aspects of the present invention.

In a fifth aspect, the present invention relates to a method for manufacturing a microfluidic device, the method comprising obtaining a substrate with a plurality of interconnected fluidic channels, typically having an open top, providing a suspension comprising a plurality of stationary phase particles, and filling the plurality of interconnected fluidic channels with the stationary phase particles by wet rubbing using a patterned elastomeric substrate, preferably a patterned polydimethylsiloxane (PDMS) substrate.

It is an advantage of embodiments of the present invention that a filling efficiency of the fluidic channels with the stationary phase particles may be high. For example, the inventors have observed that, for filling of containers having a volume suitable for containing a single particle, a filling efficiency of up to 100% may be achieved, i.e., substantially each of said containers may be filled with a particle. At the same time, an error ratio, corresponding to a fraction of stationary phase particles that is, after wet rubbing, not located in a fluidic channel, may be smaller than 10%.

In embodiments, the suspension comprises from 1 mg/ml to 200 mg/ml, preferably from 5 mg/ml to 100 mg/ml, more preferably from 10 mg/ml to 50 mg/ml, stationary state particles. In embodiments, the suspension comprises a polar solvent, such as ethanol or isopropanol, preferably ethanol. Preferably, the suspension comprises a solvent having a dielectric constant of at least 5, preferably at least 10, more preferably at least 15. It is an advantage of embodiments of the present invention that polar solvents may provide a good solubility for the particles. In embodiments, the solvent has a vapor pressure of at least 2 kPa, preferably from 2 to 15 kPa, more preferably from 4 to 10 kPa, even more preferably from 5 to 8 kPa, at 25°C and 1atm. The vapor pressure is preferably sufficiently high so that evaporation of the solvent is fast after wet rubbing. However, whenever the vapor pressure become too high, the solvent may evaporate and be lost during the wet rubbing, which may result in the particles sticking to the patterned elastomeric substrate, e.g., the PDMS substrate.

The suspension may be formed by mixing the particles and the solvent using, e.g., a vortex mixer. Ultrasonication in an ultrasonic bath may be performed to promote suspension of the particles in the solvent.

The suspension is typically provided on a top surface of the substrate with the plurality of interconnected fluidic channels. The wet rubbing may be preformed until at least 50v-%, preferably at least 70v-%, more preferably at least 90v-%, most preferably substantially all, solvent evaporated. The steps of providing a suspension and of filling the plurality of interconnected fluidic channels with the stationary phase particles by wet rubbing may be repeated several times. For example, these steps may be performed from 1 to 20 times, preferably from 3 to 10 times.

Any features of any embodiment of the fifth aspect may be independently as correspondingly described for any embodiment of any of the other aspects of the present invention.

In a sixth aspect, the present invention relates to a system for producing a microfluidic device, the system comprising means for receiving a substrate comprising a plurality of interconnected fluidic channels, a supply system configured for providing a suspension of stationary phase particles onto the substrate, and a patterned elastomeric substrate, preferably a patterned polydimethylsiloxane (PDMS) substrate. The patterned elastomeric substrate is configured for filling the fluidic channels with the stationary phase particles by a wet rubbing movement.

Said means for receiving the substrate may be any means suitable for receiving the substate, such as a table or chemical bench, a holder, or a grabbing arm. Preferably the means for receiving the substrate comprise a fixing element adapted for fixing the substrate comprising the plurality of interconnected fluidic channels in place. It is an advantage of these embodiments that the substrate may not move while wet rubbing is applied to the substrate.

In embodiments, the supply system comprises a reservoir. Said reservoir may comprise the suspension. The supply system may further comprise a tube for transferring the suspension from the reservoir onto the substrate comprising a plurality of interconnected fluidic channels. A first end of the tube may be connected to the reservoir, and a second end of the tube may be located above the substrate, when present in the means for receiving the substrate comprising a plurality of interconnected fluidic channels. The supply system may further comprise a pump for pumping the suspension through the tube onto the substrate comprising a plurality of interconnected fluidic channels.

In embodiments, the system comprises means for applying a rubbing movement of patterned elastomeric substrate, e.g., of the patterned polydimethylsiloxane (PDMS) substrate, over the substrate comprising a plurality of interconnected fluidic channels. For example, the patterned elastomeric substrate may be fixed to a motorized arm or plate configured for providing the rubbing movement.

Any features of any embodiment of the sixth aspect may be independently as correspondingly described for any embodiment of any of the other aspects of the present invention.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

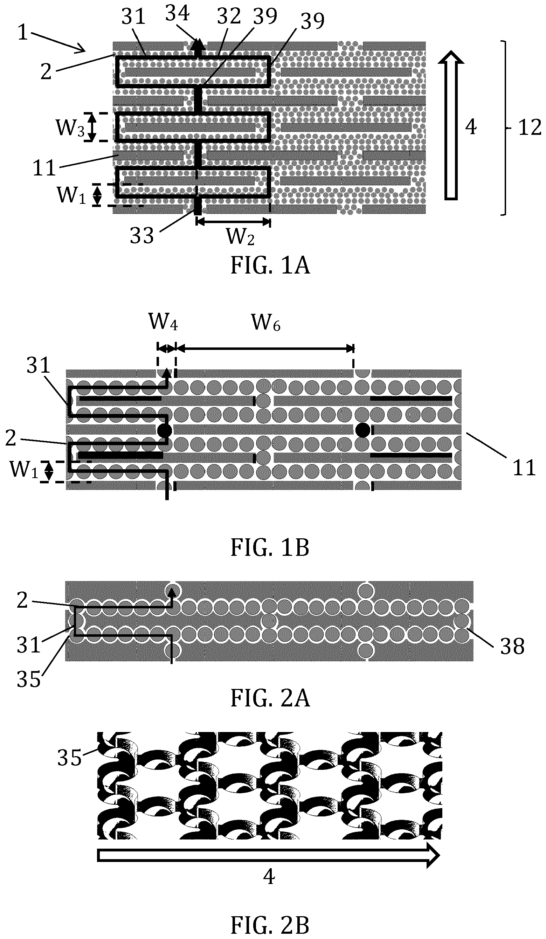

FIG. 1A and FIG. 1B are schematic horizontal cross-sections of part microfluidic devices in accordance with embodiments of the present invention, having a channel width of 4 particles and 1.3 particle, respectively.
FIG. 2A-D are schematic horizontal cross-sections of part microfluidic devices in accordance with embodiments of the present invention having particles packed in serially connected containers.

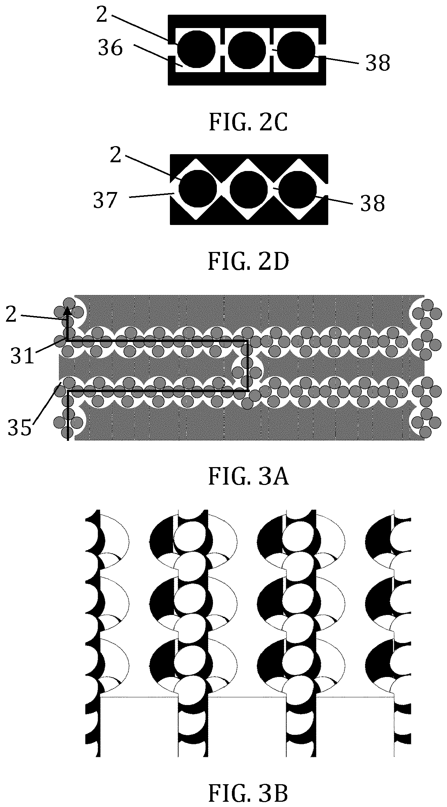

FIG. 3A and FIG. 3B are a schematic horizontal cross-sectional, and a three-dimensional, representation of channels formed of fluidically connected cylindrical containers in accordance with embodiments of the present invention.

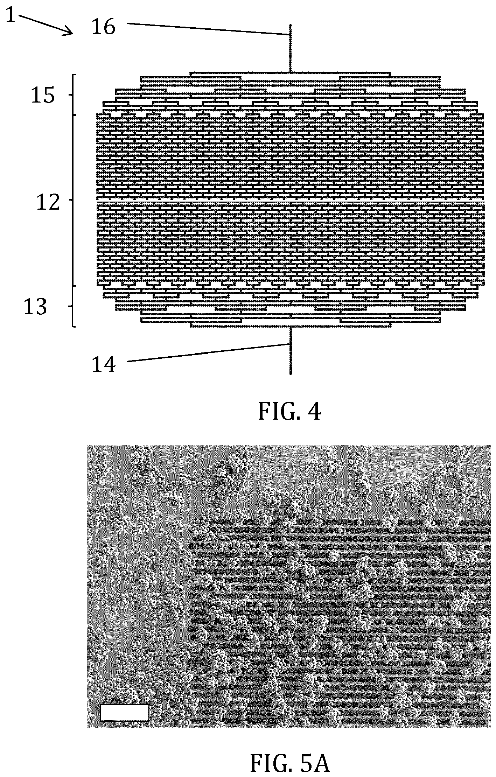

FIG. 4 is a schematic representation of a microfluidic device in accordance with embodiments of the present invention, comprising a first flow distributor and a second flow distributor.

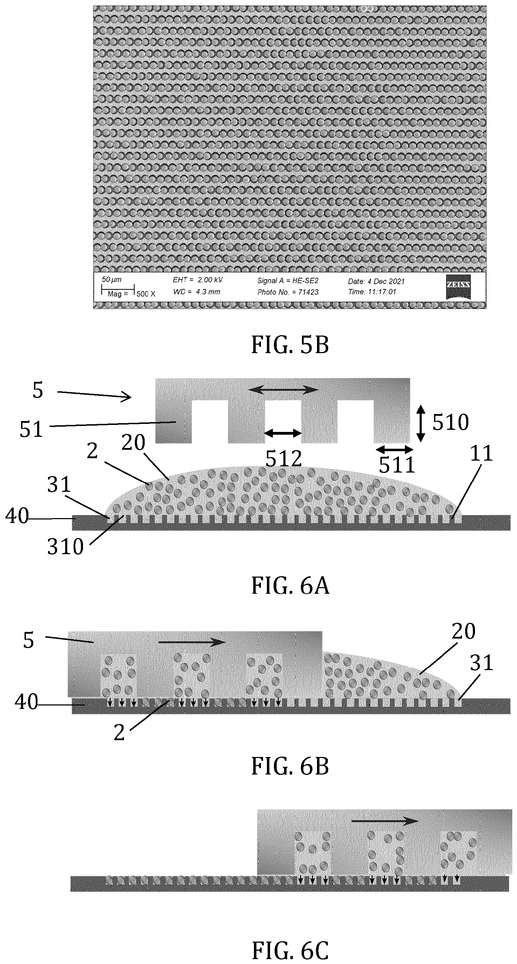

FIG. 5A and FIG. 5B are SEM images of a filled segmented column using particle sedimentation of the prior art, and a wet rubbing filling method according to the present invention, respectively.
FIG 6A-D schematically represent different steps in a wet rubbing filling method using a patterned slab, in accordance with embodiments of the present invention.

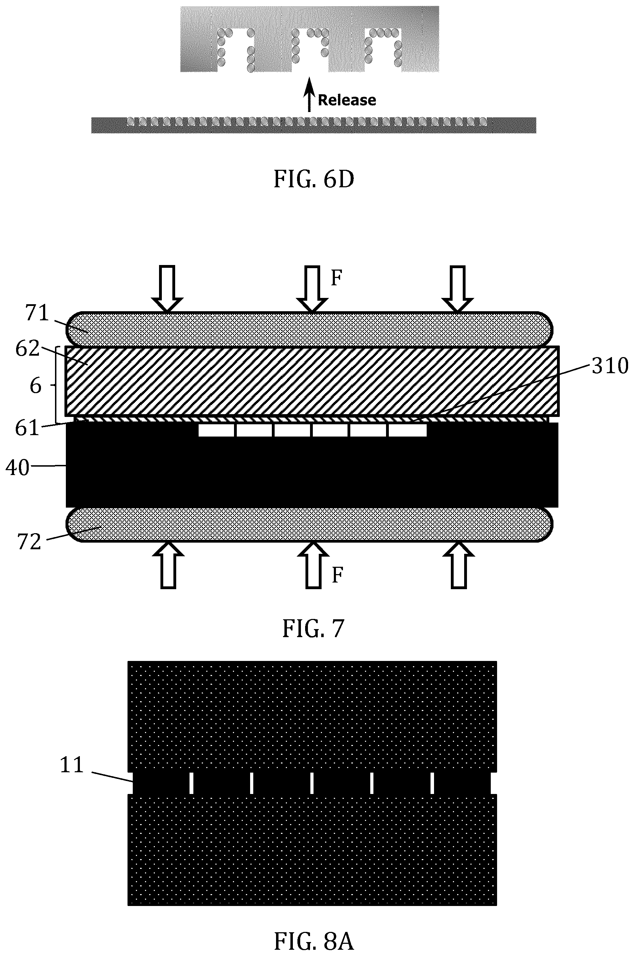

FIG. 7 is a schematic vertical cross-section of a microfluidic device in accordance with embodiments of the present invention.

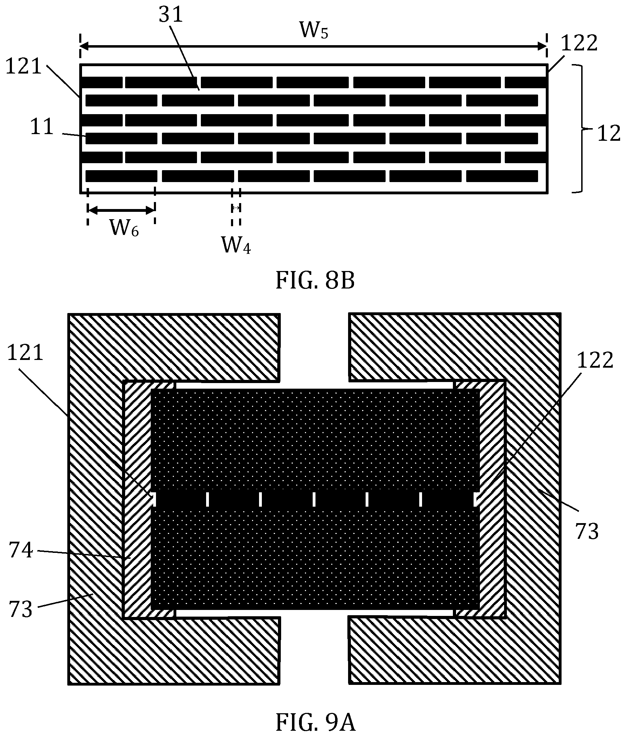

FIG. 8A and FIG. 8B schematically represent a vertical cross-section and a horizontal cross-section, respectively, of a microfluidic device in accordance with embodiments of the present invention.

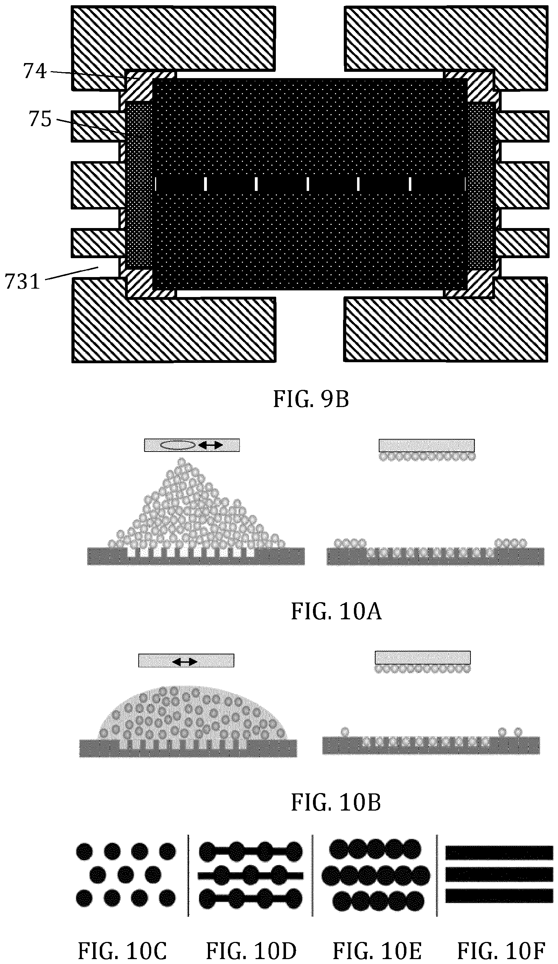

FIG. 9A and FIG. 9B are schematical vertical cross-sections of different exemplary microfluidic devices, after filling of the channels with particles from the side, and after both side-wall ends have been glue-sealed using U-shaped end-fitting pieces.
FIG. 10A-B are schematic representations of the adopted dry (A) and wet (B) rubbing procedures for the assembly of particles into micromachined pockets and grooves. Rubbing is carried out with a PDMS tool (brown). The arrows indicate the motion of the rubbing tool: circular for the dry conditions and unidirectional for the wet conditions. FIG. 10C-F are schematic top-views of the considered pocket and groove structures: unconnected (C), interconnected by channels (D), directly connected to form a microgroove pattern (E) or straight channels (F).

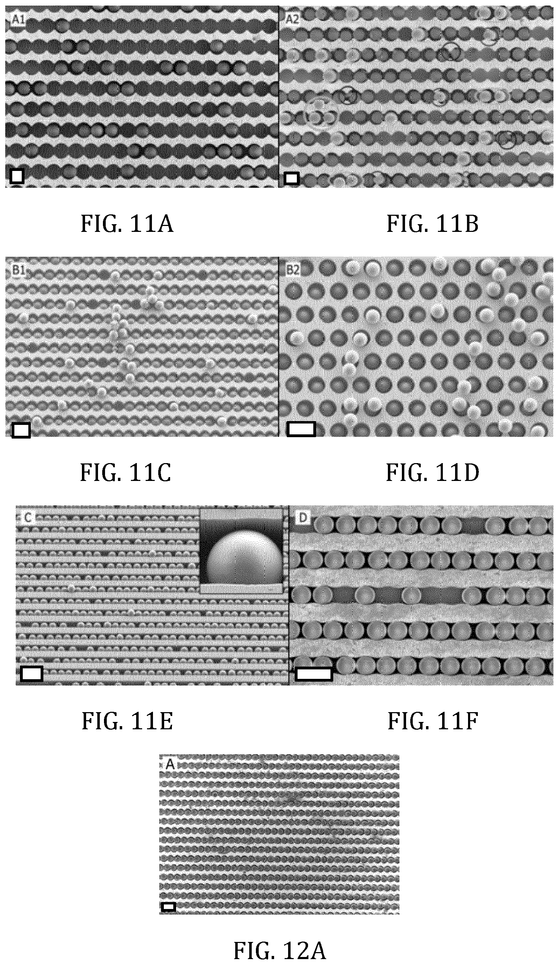

FIG. 11A-D are SEM pictures of typical dry assembly experiments carried out with 10µm silica (A, B) and 10µm polystyrene (C, D) particles. Arrays have been either been filled by applying a single (A, C) or at least 3 consecutive (B,D) rubbing runs. FIG. 11E-F are SEM pictures of typical result obtained with 5µm silica particles in straight and wavy channels.

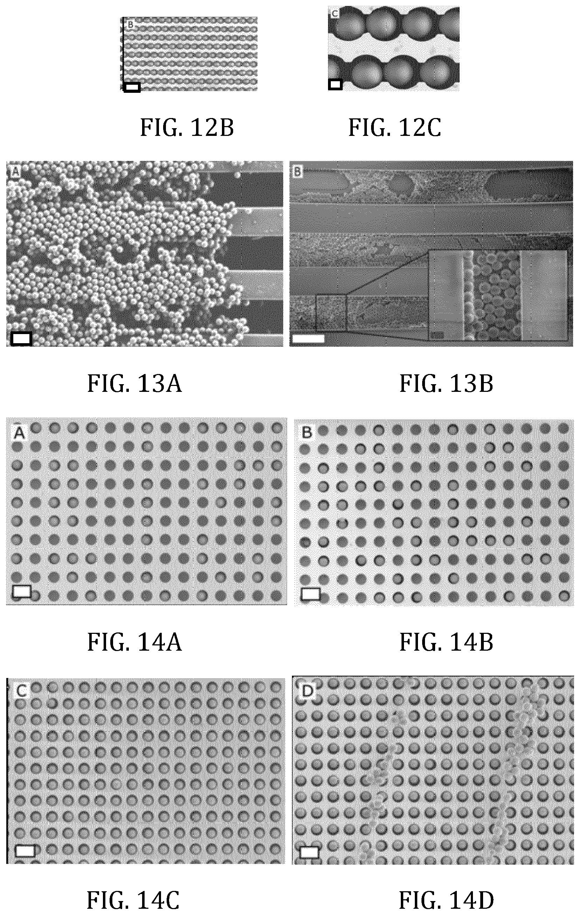

FIG. 12A-C are SEM pictures at different scales of typical wet assembly experiments carried out with 10µm silica particles by means of a single wet rubbing run with a patterned PDMS rubbing tool under optimal conditions. Sample dimensions: 10x10 mm. Experimental conditions: applied amount of particles = 30 µl of a 20 mg/ml suspension in ethanol; 1 minute evaporation time before initiating a circular rubbing motion with a patterned PDMS substrate with 50 µm grooves. Scale bar FIG. 12A: 10 µm. Scale bar FIG. 12B: 3 µm. Scale bar FIG. 12C: 20 µm.
FIG. 13A-B are SEM pictures of the patterned PDMS rubbing tool after a dry (A) and a wet (B) rubbing assembly process with 10 µm silica particles. The ridge pattern on the tool is 50 µm wide as well as deep. Evaporative fronts are indicated in red. The quasi monolayers that have been formed on the sidewalls and bottom of the grooves in the PDMS rubbing tool can be seen in the right bottom corner of A. Scale bar FIG. 13A: 30 µm. Scale bar FIG. 13B: 10 µm. Scale bar inset FIG. 13B: 100 µm.
FIG. 14A-D are SEM pictures showing the effect of a suspension concentration variation study (wet assembly): 5 mg/ml (A), 10 mg/ml (B), 20 mg/ml (C) and 50 mg/ml (D). Other conditions: deposition of a 30 µl drop of suspension in ethanol to the substrate; 1 minute evaporation time before initiating a unidirectional rubbing motion with a patterned PDMS substrate with 50 µm ridges. Scale bar: 20 µm.

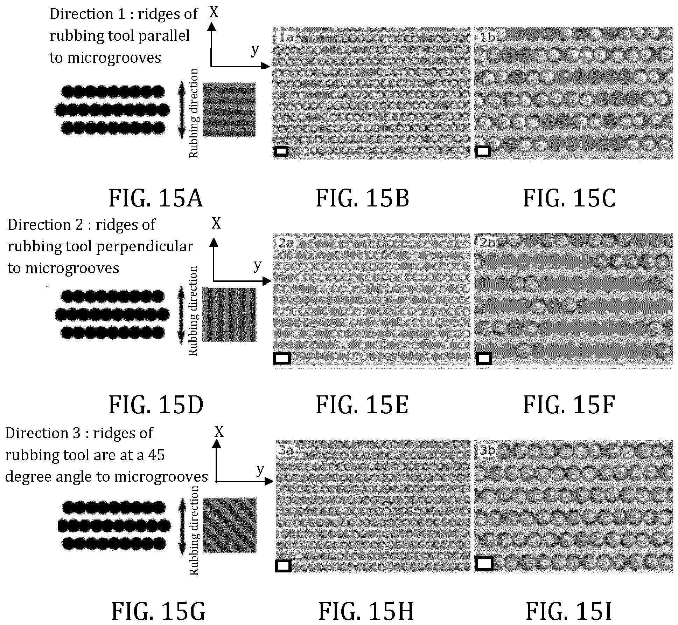

FIG. 15A-I are figures showing the indicating of the rubbing on PDMS pattern orientation for the achieved filling quality (wet assembly). FIG. 15A: ridges of the rubbing tool parallel to the microgrooves on the substrate, and FIG. 15B-C: SEM images of the result. FIG. 15D: ridges of the rubbing tool perpendicular to the microgrooves on the substrate, and FIG. 15E-F: SEM images of the result. FIG. 15G: ridges of the rubbing tool at 45° with respect to the microgrooves on the substrate, and FIG. 15H-I: SEM images of the result. Scale bar in FIG. 15B, E, H: 10 µm. Scale bar in FIG. 15C, F, I: 20 µm.

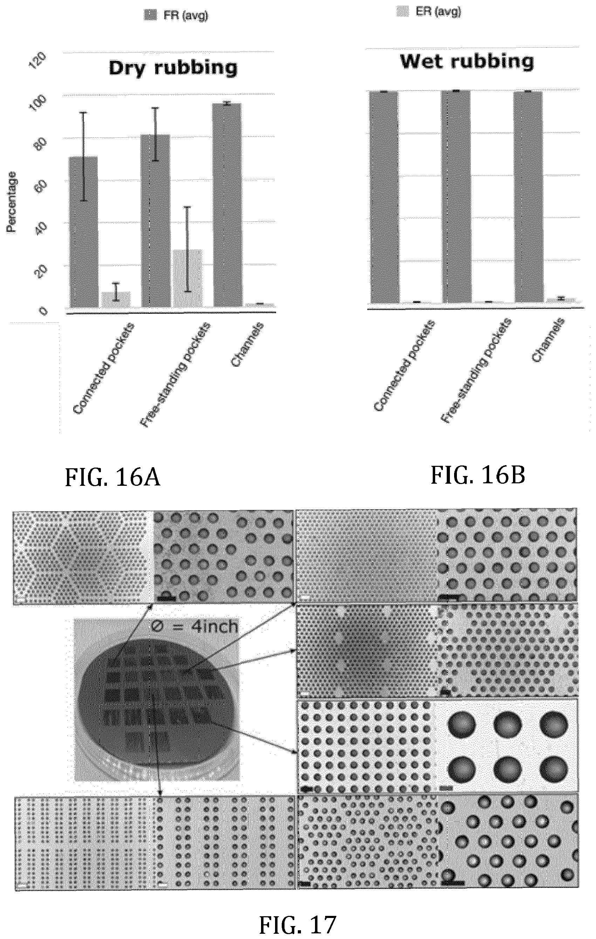

FIG. 16A-B is a graph showing the average values for the filling ratio (FR) and error ratio (ER) after dry (FIG. 16A) and wet (FIG. 16B) experiments for varying geometries of the patterned silicon substrate (connected pockets, freestanding pockets and channels) filled with 10 µm silica particles. Experimental conditions; for dry rubbing (left): deposition of a 10 mg scoop of dry particles to the substrate, followed by unidirectional or circular rubbing motion with a flat PDMS rubbing tool; for wet rubbing (right): deposition of a 30 µl drop of a 20 mg/ml suspension in ethanol to the substrate; 1 minute evaporation time before initiating a unidirectional rubbing motion with a patterned PDMS substrate with 50 µm ridges.
FIG. 17 are SEM pictures of particle assembly on substrates with different geometries (wet assembly, 10µm silica particles). Experimental conditions: deposition of a 30 µl drop of a 20 mg/ml suspension in ethanol to the substrate; 1 minute evaporation time before initiating a unidirectional rubbing motion with a patterned PDMS substrate with 50 µm ridges. Scale bar: blue = 20 µm, green = µµm, white = 40 µm

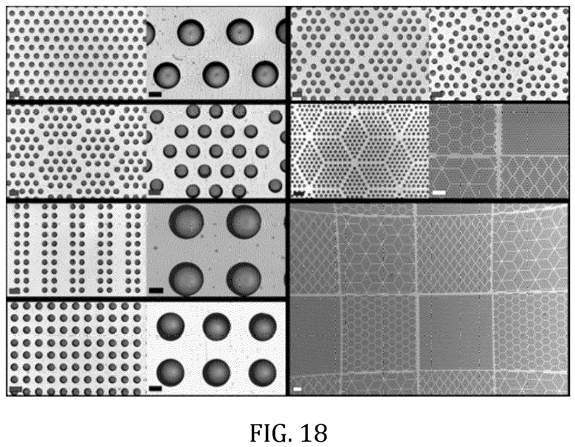

FIG. 18 are SEM pictures of particle assembly on substrates with different geometries (wet assembly, 10µm polystyrene particles). Experimental conditions: deposition of a 30 µl drop of a 20 mg/ml suspension in ethanol to the substrate; 1 minute evaporation time before initiating a unidirectional rubbing motion with a patterned PDMS substrate with 50 µm ridges. Scale bar: black = 5 µm, blue = 40 µm, green = 20 µm, red = 10 µm, white = 100 µm.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In a first aspect, the present invention relates to a microfluidic device comprising a fluidic inlet and a fluidic outlet. The microfluidic device comprises a plurality of interconnected fluidic channels, fluidically coupling the fluidic inlet to the fluidic outlet, wherein a net nominal flow direction of each of the plurality of interconnected fluidic channels is substantially parallel. The fluidic channels comprise a plurality of stationary phase particles. Within each fluidic channel, neighbouring particles, along a local flow direction, are separated from each other by a mean distance that is at most half of a mean diameter of the particles.

Reference is made to FIG. 1A. As an example of the present invention, FIG. 1A schematically shows a part of horizontal cross section of a microfluidic device 1 in accordance with embodiments of the present invention. The microfluidic device comprises a plurality of channels 31, 32, i.e., flow paths, indicated by the white arrows, defined by structuring element 11. The channels 31, 32 have a net nominal flow direction 4. The plurality of interconnected channels 31, 32 may be considered to be comprised in a column segment 12 of the microfluidic device 1, wherein the column segment 12 may be used for chromatography, e.g., as a replacement for chromatography columns of the state of the art.

In this example, the channels 31, 32 have a width W₁, perpendicular to a local flow direction and in the horizontal plane, of four times a mean of width of the particles. In other words, the distance between the structuring elements 11 is four particle diameters wide. In this example, the channels 31, 32 are parallel, that is, the net nominal flow direction for each channel 31, 32 is parallel with respect to each other, and with respect to the net nominal flow direction 4 through the column segment 12, e.g., through the microfluidic device 1. In this example, the channels 31, 32 do not cross each other (although there are fluidic connections 39 between adjacent channels 31, 32). As such, in FIG. 1A, four such channels may be identified, two of which are indicated in the left half of the figure by references 31 and 32; two further channels are present in the right half of the figure.

The advantageous effect of the channels 31, 32 having a width W₁ of four particles with respect to a conventional packed bed column (typically order of 100's and even up to 1000's of particles wide), is that it has recently been demonstrated theoretically that, when packing particles in a narrow capillary, i.e., channel, that is only a limited number of particle 2 diameters wide (number smaller than 10), a reduction of the plate height of up to a factor of two can be expected (going from minimal plate height = two for capillaries having a larger width). The microfluidic device 1 in accordance with embodiments of the present invention, which may be a substitute for chromatography columns of the state of the art, may allow to exploit this effect in a parallel array of such narrow capillaries, i.e., channels (e.g., arrows 31 and 32, illustrating the parallel nature of the different flow-through paths), an array that is furthermore organized such that the different flow-through paths, i.e., channels 31, 32, are in direct hydraulic contact over the largest part of their trajectory along the plurality of fluidic channels 31, 32 of the microfluidic device 1. Indeed, the fluidic channels 31, 32 are interconnected at a plurality of locations along the net nominal flow direction 4. A distance along the net nominal flow direction 4, between subsequent locations 39 wherein a fluidic channel is connected to an adjacent fluidic channel, is preferably limited and is, in this example, negligible. Because of that, the pressure differences between different channels 31, 32 one can expect to occur, because of inevitable small differences in packing density (and, hence, differences in flow resistance) of the different flow-through paths, i.e., channels 31, 32, can be easily equilibrated in a direction perpendicular to the net nominal flow direction 4, in the (shown) horizontal plane, thus homogenizing fluid flow velocities, in the net nominal flow direction 4, for the different flow paths, i.e., channels 31, 32.

In this example, the channels 31, 32 are meandering around the structuring elements 11. A meander ratio may be defined as a ratio of the total inner length of the meandering channel 31, 32 to the shortest distance between the first end of the channel 33 to a second end of the channel 34, As such, in this example, the meander ratio may be defined as (6·W₃+6·W₂) / (6·W₃), with W₂ a distance between subsequent openings in structuring elements 11 along the channel 31, 32, and W₃ a distance, in a direction along the net nominal flow direction 4, between two parts of the channel 31, 32 separated by a single structuring element 11. Preferably, the meander ratio is at least 1.5, so that the flow channel is for a large part confined between structuring elements 11, so that a large part of the channel 31, 32 has a limited width W₁, while at the same time the above mentioned equilibration of pressure forces is possible.

The advantage of having an array of said flow-through paths 31, 32 resides in that it may bring a sufficient number of molecules to a detector, which may be coupled to the outlets 34. This is why industry is interested in using 0.5 to 1mm wide columns and not just using single packed 10 or 20 µm capillaries. Considering for example a channel with a depth of 100 µm, and a flow-through channel width of 10 µm (capable of accommodating five 2 µm particles), a column segment that is 1000 of such channels wide would be able to accommodate the same flow rate as a cylindrical 1mm diameter column, while maintaining the same interstitial velocity. Having, for example, flow-through channels with an aspect-ratio of 5 (W₂ over W₁=5), this would correspond to a column segment that is 5 cm wide. This is a width fitting perfectly on a 4 inch silicon wafer, and certainly on a 6 or 8 inch wafer. Obviously, making the channels deeper, may reduce the preferred column segment width.

Reference is made to FIG. 1B, which is another schematic horizontal cross-section of an example of part of a microfluidic device in accordance with embodiments of the present invention. The flow-through paths, e.g., channels 31, could be made as narrow as a single particle 2 diameter. Please note that, in practice, such a single-particle flow-through channel is, preferably, 1.1 to 1.3 particles wide, so as to accommodate for the size variability of the particles 2 that may be inherent in any commercially available batch of stationary phase particles 2. The advantage of such a single flow-through channel 31 is that the packing density would be smallest (particles can not tip into any of the dense fcc or bcc 3D packing configurations as this movement is blocked by the presence of the structuring elements 11). As such, this lower packing density may lower the pressure resistance along the flow-through paths 31 compared to the wider channels that are capable of stacking particles in a more dense way. It can also be argued that, because of the maximal restriction of the particle movement, fewer packing configurations are possible, such that the obtained packing would also be more ordered in the present example, than in the multi-particle wide flow-through channels such as those shown in the example of FIG. 1A. In this example, the lateral width W₆ of the structuring elements 11 is more than five times as large as the lateral width W₄ of an opening between the structuring elements 11. The lateral width W₄ of the opening is typically between 0.5 and 1.5 times the mean width W₁ of the channels 31 and 32.

Reference is made to FIG. 2A, which is still another schematic horizontal cross-section of an example of part of a microfluidic device in accordance with embodiments of the present invention. To achieve good ordering of the particles 2 along the flow direction of the flow-through paths, i.e., channels 31, this channel 31 is, in this example, a series connection of partially overlapping, and interconnecting cylindrical containers 35. When the containers 35 may, in the horizontal plane, only accommodate a single particle 2, all particles 2 in the channel 31 will be at a well-defined location, thus further improving the order of the packing. Preferably, the degree of overlap between the different containers 35 is such that the distance between the center points of two adjacent containers is maximally 1.5 particle diameters. Thereby, a high packing density may be achieved. The containers 35 are fluidically coupled to each other through a coupling channel 38. Preferably, the coupling channels 38 has a width that is smaller than a mean width of the particles 2.

Reference is made to FIG. 2B, which is a three-dimensional representation of a microfluidic device, wherein the channels are also formed of cylindrical containers. The meander ratio in this specific example is below 1.5.

Reference is made to FIG. 2C and FIG. 2D. Instead of cylindrical containers, a rectangular cuboid container 36, 37, such as a square cuboid container, having a square shaped horizontal cross-section, could be used. An advantage of a cylindrical shape is that a large particle to liquid volume ratio may be achieved, in turn maximizing the separative power of the microfluidic device. Also these containers 36, 37 are fluidically coupled to each other through a coupling channel 38. Preferably, the coupling channels 38 have a width that is smaller than a mean width of the particles 2.

Reference is made to FIG. 3A, which is a schematic representation of a horizontal cross section of part of an example of a microfluidic device in accordance with embodiments of the present invention. Further reference is made to FIG. 3B, which is a three-dimensional representation of part of the same microfluidic device. It may be anticipated that, in some applications, beneficial effects may be expected from design variants wherein each container 35 is capable of receiving two or three particles 2 per diameter, e.g., when a mean diameter of the containers 35 is from 2.0 to 2.9, or from 3.0 to 3.9, respectively, preferably from 2.2 to 2.5, or from 3.2 to 3.5, respectively, times a mean diameter of the particles 2. One such beneficial effect is that it may facilitate making deeper channels, which may reduce a footprint and, hence, a cost of the microfluidic device. Indeed, the maximal depth of the flow-through channels 31 is linked to the smallest dimensions, which in this case may correspond to the width of the containers 35. This may result from an upper limit on the aspect ratio of the depth to the width of the trenches that can be etched in silicon while maintaining substantially vertical side-walls. The latter is preferred because otherwise undesirable velocity gradients may develop in the depth direction (i.e., perpendicular to the plane of FIG. 3A).

Reference is made to FIG. 4, which is a schematic representation of a fluidic device 1 in accordance with embodiments of the present invention. The fluidic device 1 comprises a plurality of parallel fluidic channels, comprised in a column segment 12 of the fluidic device 1. To achieve a substantially equal flow rate, and pressure, in each channel of the column segment 12, a first flow distributor 13 may be introduced at the beginning and end of the column segment 12. Said first flow distributor 13 may comprise bifurcating channels, bifurcating from the fluidic inlet 14, which in this example is a single device inlet 14, to a first end of each of the plurality of interconnected channels comprised in the column segment 12. A second end of each of the plurality of interconnected channels may be connected to a second flow distributor 15, comprising bifurcating channels, bifurcating from an outlet 16, which in this example is a single device outlet, to the second end each of the plurality of interconnected channels. Any features of the bifurcating channels of the flow distributors 13 and 15 may independently be the same as any features mentioned with respect to the interconnected fluidic channels of the plurality of fluidic channels of the column segment 12. For example, the bifurcating channels of the flow distributors 13 15 may also comprise stationary phase particles.

During production of the microfluidic device 1 of the present invention, particles may be introduced through the top of the microfluidic device 1, into the plurality of interconnected fluidic channels of the column segment 12, and possibly into the bifurcating channels forming the flow distributors 13 and 15. When filling the plurality of interconnected fluidic channels of the column segment 12 with said particles from the top, it is advantageous when the flow distributors 13 and 15 are designed such that the bifurcating channels forming the flow distributor 13 are filled in a uniform way, and, preferably, with the same ease as the plurality of interconnected fluidic channels of the column segment 12. For example, this may prevent particles agglomerating on top of the flow distributors 13 and 15. Therefore, preferably, the bifurcating channels of the flow distributors 13 and 15, and any connection channels connecting the flow distributors 13 and 15 to the column segment 12, have substantially the same width, and preferably also substantially the same height, as the channels of the column segment 12.

In a third aspect, the present invention relates to a method for manufacturing the microfluidic device according to embodiments of the first aspect of the present invention, or for manufacturing the microfluidic device of the chromatography device according to embodiments of the second aspect of the present invention. The method comprises obtaining a substrate comprising the plurality of interconnected fluidic channels. The method further comprises filling the interconnected fluidic channels with a suspension comprising the plurality of stationary phase particles, dispersed in a fluid.

In a fifth aspect, the present invention relates to a method for manufacturing a microfluidic device, the method comprising obtaining a substrate with a plurality of interconnected fluidic channels, typically having an open top, providing a suspension comprising a plurality of stationary phase particles, and filling the plurality of interconnected fluidic channels with the stationary phase particles by wet rubbing using a patterned elastomeric substrate, preferably a patterned polydimethylsiloxane (PDMS) substrate.

Reference is made to FIG. 5A. The inventors have observed that filling the plurality of interconnected fluidic channels from the top, using the sedimentation technique disclosed in WO2004046020A2, may yield inefficient filling and inhomogeneous filling results. FIG. 5A is a SEM image of an experiment of filling a microfluidic device not comprising stationary phase particles, with the stationary phase particles, in accordance with the method of WO2004046020A2).

The step of obtaining the plurality of interconnected fluidic channels may be performed by any method know to the person skilled in the art. For example, the plurality of interconnected fluidic channels may be obtained by etching the channels in a substrate, such as in a silicon wafer.

The step of filling the interconnected fluidic channels with a suspension comprising the plurality of stationary phase particles, dispersed in a fluid, may be performed by filling the channels with particles from the top, when obtaining the plurality of interconnected fluidic channels comprises obtaining the fluidic channels such that each fluidic channel has an opened top.

Reference is made to FIG. 6A-D, which schematically show steps in an exemplary technique of filling the plurality of interconnected fluidic channels in accordance with embodiments of the present invention. Herein, a substrate 40 comprising a plurality of interconnected fluidic channels 31 formed by structuring elements 11, and possibly comprising a flow distributor comprising a bifurcating channels, is obtained, wherein their top is opened 310. The technique of this example comprises the following steps:
i) (referring to FIG. 6A) depositing a suspension 20 with a concentration preferably ranging between 1 mg and 100 mg of particles 2 per mL on top of an upper surface of the substrate 40 comprising the plurality of interconnected fluidic channels 31, and possibly comprising a flow distributor comprising a bifurcating channels,
ii) (referring to FIG. 6B, FIG. 6C, and FIG. 6D) rubbing said suspension 20 along the upper surface of the substrate using a patterned slab 5, so as to rub the particles 2 into the channels 31 (FIG. 6B and FIG. 6C) and subsequently releasing the slab from the upper surface (FIG. 6D), and
iii) preferably, removing any remaining particles sticking to the upper surface of the substrate using a liquid jet, air jet, a slab-like material with adhesive properties, or any mechanical scraping device adapted for removing any remaining particles on the upper surface, while not removing the particles inside the channels.

Between step ii) and iii), steps i) and ii) may be repeated, e.g., a single, or several times.

The patterned slab 5 used in step ii) may, for example, be a patterned polydimethylsiloxane (PDMS) slab. The patterned slab 5 may comprise an array of, preferably substantially parallel, rectangular ridges 51, separated from each other by a spacing 512 of from 10 to 1000 µm, preferably from 40 to 100 µm. The rectangular ridges preferably have a height 510 from 10 to 1000 µm, preferably from 40 to 100 µm. Each rectangular ridge preferably has a width 511, in a direction along the array of rectangular ridges, of from 10 to 1000 µm, preferably from 40 and 100 µm.

Preferably, step ii) is performed such that an angle between a direction along the array of ridges and a net nominal flow direction of the plurality of interconnected channels is from 20 to 70°, more preferably from 30 to 60°, even more preferably substantially 45°.

Reference is made to FIG. 5B, which is a SEM image of a plurality of channels that were filled with stationary phase particle by using the above technique, which is in accordance with embodiments of the present invention. It may be observed that uniform filing may be achieved.

After said filling of the plurality of interconnected channels from the top, the channels may be sealed by applying a lid, e.g., a cover plate. Said lid may comprise a thin layer of pre-cured glue on a surface of the lid for contacting the substrate comprising the interconnected channels. For example, this thin layer may be applied on the lid using spin coating of a diluted solution of pre-cured glue, so to generate a layer that is at most 1 µm thick. Typical glues that may be used are SU-8, NOA-81, and optical lens bond materials (e.g., SK-9), but the invention is not limited thereto.

Reference is made to FIG. 7. In an alternative approach, the (opened) top 310 of the channels may, after filling from the top, be sealed by covering the top surface of the substrate 40 by an elastic lid 6, comprising an intermediate elastic layer 61 directly over the channels 31, preferably formed of a chemically inert material, such as for example PEEK or PTFE. The elastic lid 6 may comprise a further elastic layer 62, that may be thicker and may provide mechanical robustness. A mechanical clamping force may be applied, via clamping elements 71 and 72, which are preferably rigid clamping elements 71, 72, to counter any pressure forces from inside the channels 31 applied on the elastic lid 6. Said mechanical clamping force is preferably at least applied during operation of the microfluidic device, e.g., when it is used for performing chromatography.

In an alternative approach, the channels may be filled with particles from the side, using a technique in accordance with embodiments of the present invention. In this case, the structuring elements preferably have substantially flat side-walls. For example, it may not be possible to use the connected container structures shown in FIG. 2A-D and FIG. 3A-B in this alternative approach. Filling from the side may provide the advantage that anodic bonding may be used to attach a lid to close the top of the channels in the substrate prior to said filling. Anodic bonding may provide a much higher bonding strength than what may be achieved with glue or an intermediate elastic layer as described above. Anodic bonding further avoids any chemical interferences with the glue or the intermediate elastic layer. Anodic bonding is, preferably, only used before the particles are present, as, in particular, HPLC stationary phase particles may not withstand the high temperatures (>300°C) typically used in anodic bonding. Another advantage of the side-filling approach is that the only regions that may need to be sealed after the filling are the lateral side walls. These have an open surface that is much smaller than the surface that may need to be sealed after filling using the top filling approach described above. Thereby, the force exerted by the pressure in the channels that is to be countered by this side-filling process, may be at least one order of magnitude smaller than in the top-filling case.

Reference is made to FIG. 8A, which is a schematical vertical cross-section of a microfluidic device, before filling with stationary state particles, and FIG. 8B, which is a schematical horizontal cross-section of the microfluidic device, before filling with the stationary state particles. For filling the plurality of interconnected channels 31 from the side, the substrate comprising the column segment 12 comprising the plurality of interconnected fluidic channels 31, preferably, has substantially flat and substantially vertical side-walls. The substrate, preferably, has a width W₅ from side 121 to side 122 substantially equalling the sum of n times the lateral width W₆ of the structuring elements 11 and n times the lateral width W₄ of an opening between the structuring elements 11, i.e., W₅ = n · (W₆ + W₄), with n an integer. Any deviations for the width W₅ of the substrate is preferably at most 2 µm, preferably at most 0.5 µm, and more preferably at most 0.2 µm. Using state-of-the-art Deep Reactive Ion Etching, etching channels in a substrate may be possible to within an accuracy of a few hundred nm, although also other etching techniques may be used that achieve such an accuracy. These tight tolerances are preferred so that, after filling the channels 31 with the particles and when in use for, e.g., chromatography, the channels 31 near the two sides 121, 122 of the column segment 12 have substantially the same flow length and filling degree (and, hence, the same flow resistance) as the channels 31 in the center of the column segment 12. If this condition would not be fulfilled, the difference in flow resistance (and hence in local velocity) can be expected to lead to dispersion effects when, e.g., performing chromatography.

Reference is made to FIG. 9A. The sides 121, 122 may be sealed after filling by fixing U-shaped endpieces 73 on each side of the device. The U-shaped endpieces 73 may be fixed using a photo- or thermocurable glue 74. Said glue 74 preferably comprises a high inorganic content to minimize interference with any solvent used during chromatography. Suitable endpieces 74 may be produced using e.g. 3-D printing, hot embossing or micromilling. Said endpieces 74 may be formed, for example, of a polymer or of a metal.

Reference is made to FIG. 9b. In an advanced option, the side-walls can, prior to applying the glue, first be covered with a sealing cover 75. Said cover 75 may be formed of an polymeric, organic or inorganic material. Said sealing cover 75 may be fully impermeable, or may be perforated with glue-accommodating pores or holes. In preferred embodiments, the endpieces are perforated with through-holes 731, enabling a swift escape of any excess glue 74.

Now, an exemplary approach is detailed for filling the channels from the top. By way of illustration, embodiments not limited thereto, standard and optional features of embodiments of the present invention are illustrated in the example given below.

The large-scale assembly of spherical particles into a closely packed, hexagonal monolayer or in any other desired two-dimensional (2D) configurations has been of particular interest in many scientific studies. Manufacturing such controlled configurations of micro- or nanoparticles paves the way to a wide range of possible applications. Particle arrays can, for example, be used in micro-engineering as a lithographic mask, allowing for the fabrication over a large area of micro- and nanostructures, such as three-dimensional inverse woodpile photonic crystals. Next to this, the periodicity in the monolayers is an essential key feature in a vast number of applications, such as photonics, light manipulation devices, optical and biological sensors, wearable medical devices, chemical catalysis, super hydrophilic, superhydrophobic or self-cleaning antireflective surfaces and many more. Finding generic particle assembly methods that are independent of the size and the material of the particles is hence of paramount importance. Over the last few decades, various techniques have been developed to find a reproducible and cheap way to assemble particles on a large scale in monolayers on flat substrates or in structured arrays on patterned substrates. Most studies exploit wet assembly techniques, such as Langmuir-Blodgett, evaporative slope self-assembly, dipcoating, drop-casting, spin-coating, techniques involving the application of an electric field, and many more. Recent research has shown that the surface wettabillity has an significant effect on the self-assembly of spherical particles from colloidal suspensions upon evaporation. Alternatively, a large-scale dry particle assembly process has been proposed by the Jeong group. This was successfully applied for the formation of large-area colloidal monolayers on flat, curved as well as pre-patterned substrates by means of unidirectional rubbing of dry powder using an elastomeric material. Nevertheless, wet assembly methods are in literature still generally preferred over dry methods as the interaction forces between particles in suspension are noticeably weaker than in a dry state.

Whereas the aforementioned studies mainly focused on the production of particle arrays and layers on flat or weakly structured surfaces, the present study focuses on the possibility to assemble microsphere particles (5 and 10 µm diameter) in arrays of micro-machined pockets, i.e., containers, wherein the particles can be completely sunk into the substrate (depth pocket ≥ diameter particle). Particle assembly is achieved using PDMS rubbing. Both dry rubbing (FIG. 10A), as introduced by the Jeong group (see PARK, ChooJin, et al. Quick, large-area assembly of a single-crystal monolayer of spherical particles by unidirectional rubbing. Advanced Materials, 2014, 26.27: 4633-4638; and PARK, ChooJin; KOH, Kunsuk; JEONG, Unyong. Structural color painting by rubbing particle powder. Scientific reports, 2015, 5.1: 1-5) is used, as well as a novel wet rubbing variant, i.e., by applying the particles in the form of a wet suspension rather than in the dry state (FIF. 10B).

A comparison between both methods is made. Four different geometries are considered: individually separated (FIG. 10C) and linearly connected pockets (FIG. 10D-E), as well as straight channel geometries (FIG. 10F). The linearly connected pockets, also referred to as microgrooves, are of particular interest as this is a design allowing to keep the particles in a fixed location while a flow of liquid or gas is sent past them. The other geometries are extreme cases where the geometry of the pockets is varied, either loose pockets or no pockets at all (for straight channels), to test the effect on the assembly process. This form of fully-sunk particle entrapment potentially enables the use of stringent cleaning methods (to remove misplaced or excess particles) and allows to put the particles in a sealed liquid or gas environment. Possible applications are in rapid screening assays, catalytic microreactors or liquid chromatography separations. Inspired by the work of Izadi on the development of a soft cleaning method for micro-fabrication (IZADI, Hadi, et al. Removal of particulate contamination from solid surfaces using polymeric micropillars. ACS applied materials & interfaces, 2016, 8.26: 16967-16978), we also considered the use of patterned elastomeric rubbing substrates as an alternative to the flat PDMS substrates used in most other particle rubbing studies. To investigate the versatility of the technique, the developed techniques have been applied for both silica and polystyrene microspheres. The focus is on their ability to assemble 5 to 10 µm particles into arrays of micro-pockets (either connected or disconnected) designed to receive individual particles (FIG. 10C-F).

The particles, i.e., stationary phase particles, were dispersed in solvents (Sigma Aldrich) with 99% purity and filtered with a 0.2µm PTFE syringe filter (Thermo Scientific ^{™}) to avoid particulate contaminants. Filling of the silicon microgroove patterns with particles was performed under ambient conditions.

Experiments were performed with hydrophilic silica particles (diameters 10.02±0.32 µm and 4.64 ± 0.14 µm) and hydrophobic polystyrene particles (diameters 10.14 ± 0.12 µm) that were purchased from Microparticles GmbH. Standard deviations on the particle diameter were supplied by the manufacturer.

Microfabrication processing has been performed at the MESA+ nanotechnology institute of the University of Twente. A variety of designs of the microstructures was tested and incorporated on a single silicon substrate. The design consisted of freestanding circular pockets with varying distance in between (diameter was varied from 10 to 13 µm), connected microgrooves with varying overlap of adjacent circular pockets and straight channels. The microstructures were fabricated on 4-inch silicon substrates (one side polished, (100), ptype) by standard lithographic patterning followed by a Deep Reactive-Ion Etching (DRIE) process to transfer the pattern into the bulk silicon. A three-step DRIE recipe, capable of achieving nearly vertical sidewalls with scallop size of 30nm, was used. The recipe is based on the use of C₄F₈ and SF₆ gas and was implemented on a PlasmaPro 100 Estrelas machine (Oxford instruments). The pattern was etched 12 to 13 µm deep into the silicon. Prior to the particle assembly experiments, the substrate was thoroughly cleaned by O₂ plasma (Tepla 360) to remove fluorocarbon and photoresist residue and finally with HNO₃ to remove any remaining organic residue.

Both flat and patterned polydimethylsiloxane (PDMS) rubbing tools were used for the particle assembly. To produce the flat rubbing tools, flat PDMS sheets were made by pouring PDMS (SYLGARD^{™} 184 Silicone Elastomer Kit - Dow Inc.) in a petridish and crosslinking it in an oven at 60°C for at least 4 hours. After curing, this PDMS slab was cut into the desired size and shape with a sharp blade, e.g. a scalpel. To produce the patterned PDMS tool, master molds were fabricated on regular 4-inch silicon substrates by patterning in a negative photoresist (MicroChem NANOTM SU8). The negative image of the desired pattern for the PDMS rubbing tool was transferred to the SU8 layer by means of standard optical lithography. Different patterns were considered, involving both pillars and ridges of different size in a range from 10 to 400 µm. The rubbing tool is made by pouring PDMS (ratio silicone elastomer: initiator 10:1) on top of the master mold substrate and crosslinking it in an oven, in the same manner as described above for the flat sheets. The resulting PDMS rubbing tool was obtained by separating the PDMS from the mastermold and cutting it into the desired size and shape.

The particle assembly via rubbing occurs very similar for the dry and wet procedure: the silicon substrate was secured, particles were supplied to this substrate before rubbing the flat or patterned PDMS piece manually with either a circular or a back-and-forth movement.

The number of strokes performed is in most cases in the range between 10 and 20. For extra support and to ensure a uniform contact of the PDMS with the substrate, the PDMS was taped or glued to a 3D-printed plastic holder. All the rubbing experiments were conducted in triplicate.

A scoop of about 50 mg of silica or polystyrene particle powder was weighed and supplied to a silicon substrate containing micro-pockets. The dry assembly process depicted in FIG. 10A starts by performing a circular rubbing motion for about 30 seconds to a minute (corresponding to 10-20 strokes) with the PDMS rubbing tool on top of the silicon substrate and this is defined as a single rubbing step. Subsequent visual inspection with an optical microscope was used to determine whether additional rubbing steps may be needed to achieve a desired filling ratio of 99-100%.

The particles were suspended in a solvent at the desired concentration (standard rubbing solutions were 20 and 50 mg/ml), before thorough mixing with a vortex mixer along with half an hour in the ultrasonic bath at maximum power. A drop of known volume (20-100µl) of the particle suspensions was supplied to the substrate for particle assembly. The drop was left to evaporate for at least one minute, which is defined as the waiting time, to allow the dispersed particles to sediment toward the underlying substrate. The wet assembly procedure was initiated by placing the PDMS rubbing tool on top of the previously deposited drop.

Subsequently, the rubbing motion was initiated, either a unilateral motion or circular motion depending on the size of the substrate. For full-size wafer substrates, circular motions can be performed. This is not possible for very small substrates, for which the rubbing movement was only executed unilaterally. The rubbing motion was continued until all the solvent had evaporated or preferably even a little before. A single wet rubbing procedure as defined above could be repeated multiple times until the attained filling ratio (see below) was nearly 100%.

To quantify the quality of the assembly processes, a filling ratio (FR) and an error ratio (ER) were defined for the silicon substrates after rubbing. The filling ratio is defined as the proportion of available pockets which has been filled with particles. The error ratio is defined as the number of particles deposited on unwanted locations divided by the total number of pockets. In between consecutive rubbing experiments, the filling ratio was visually checked with optical microscopy. The FR's and ER's were obtained by examining Scanning Electron Microscopy (SEM) pictures with an image processing program (ImageJ). The FR- and ER-values have been determined on a sub-set of smaller areas as calculating the ratios across the entire silicon substrate was a very laborious and time-consuming task due to the image stitching and the number of particles per sample (depending on the pattern, this is in the range from 190,000 to 360,000 particle pockets per sample). The sub-areas used to determine the filling and error ratios were at least 300x300 µm and contained a minimum of 1000 pockets and were all chosen randomly.

It is well-known that microparticles tend to aggregate due to substantial cohesive interactions, particularly under dry conditions. This highlights the preference for applying a sufficiently strong shear force during the rubbing motion to separate agglomerates into the single particles for assembling 2D particle arrays. The initial dry rubbing experiments were performed with a flat PDMS sheet using 10 µm silica or polystyrene particles on silicon chips containing microgroove patterns (FIG. 10A). After a single rubbing run, the filling of the microgrooves with silica particles was relatively poor (filling ratio FR = 20 - 25%), as can be seen in FIG. 11A. Repeating the dry rubbing process at least three times allows to attain a considerably higher FR (70-79%), as can be witnessed from FIG. 11B. The FR that can be achieved with this repeated procedure is however still far from satisfactory.

Especially because it was also found that the FR varies immensely along the substrate and consequently the reproducibility for larger samples is poor. It is assumed that the relatively high rubbing forces that may be needed to separate the strongly agglomerated microspheres into single particles cannot easily be maintained at a constant level during the rubbing process. This inevitably leads to a maldistribution of the assembly quality.

For polystyrene particles on the other hand, it was found that a single dry rubbing run was sufficient to obtain an FR of 80-85%, as is shown in FIG. 11C. In many instances, repeated rubbing with polystyrene particles even led to near-complete filling (90-99%) of the arrays (FIG. 11D). The error ratio ER (=fraction of particles at undesired places) was for both type of particles within a range of 1 to 10% for a single rubbing experiment but could attain values of up to 50% after consecutive rubbing experiments. The dry rubbing particle assembly for 5 µm silica particles (FIG. 11E and FIG. 11F) yielded similar results as those obtained for the 10 µm silica particles.

It is assumed the large ER-values are due to the large particle excess that may be needed to start-up the process. In a dry process, one scoop of particles corresponds to about 50 million particles (corresponding to an excess ratio of about 100:1 compared to the number of empty pockets), which are directly scooped onto the substrate. This massive number of particles may be needed for a smooth rubbing motion as the particle layer formed between the silicon substrate and the rubbing tool acts as a lubrication layer.

The different behaviour of the silica and polystyrene particles can potentially be ascribed to their initial state. When taking a closer look at the surface of the particles, it can be concluded that the polystyrene particles have a relatively large surface roughness compared to the silica particles, implying that there are fewer cohesive interactions among the polystyrene particles than among the silica particles. In addition, due to the silica particles' hydrophilic nature, due to humidity a capillary force may act between them, leading to a strongly agglomerated state. On the other hand, due to the hydrophobic surface of polystyrene particles, it is expected that a water layer is absent on their surface, and concomitantly the PS particle surfaces may carry a significant electrical charge, leading to a repulsive Coulomb force among the polystyrene particles with the same polarity.

As the rubbing motion is applied on the particles, they can either slide or roll across the substrate, provided the applied force surpasses the friction force restraining the movement of the particles. Considering that the dry silica powder comprises large and densely packed aggregates at the start of the rubbing process, it can be intuitively argued that these will slide in one piece across the substrate. A sufficiently strong force is preferred to separate the agglomerates into individual particles before they can get trapped inside the micro-pockets.

The polystyrene particles, on the other hand, are mostly present as single particles, except for a few small aggregates. Consequently, the external force that may be needed for the PS particles to move across the substrates is smaller than for the silica particles. As such, the polystyrene particles can be more easily assembled within the microgroove patterns. The dry rubbing experiments have been carried out on a variety of geometrical patterns. The filling results are very similar on geometries where the pockets are interconnected (FIG. 11C) as well as where they are not connected (FIG. 11D). Interestingly, when using straight channels (FIG. 11E), or channels with a mild wavy pattern (FIG. 11F), the filling process appeared to go much smoother for silica particles, and significantly higher filling ratios were observed (roughly 20% for isolated or partially connected pockets versus roughly 70% for straight or wavy channels). Our hypothesis is that the assembly of the particles in the microgrooves is hindered by the sharp edges that are a result of the overlapping circular pockets. We also suspect these sharp edges might also explain the increased particle breakage that we observe for these samples.

It is noted that, although the filling ratios obtained for dry rubbing polystyrene could in some cases attain nearly 100%, there was always some local variation in the number of unwanted excess particles (0-10%) deposited aside of the pockets. Some minor defects, such as a second layer or slightly misplaced particles (FIG. 11B), are quite commonly observed phenomena in case of dry rubbing, regardless of the pocket or channel geometry.

Although dry particle assembly methods have been successfully employed in the past to achieve assembled arrays comprising colloidal polystyrene particles on 2x2 cm² stretchable substrates as well as on rigid 10×10 cm² PDMS-coated silicon substrates, it proved difficult for us to obtain perfect assemblies on the wafer-scale, especially in case of the silica particles (FIG. 11B). One explanation could be that we employed very rigid silicon substrates, while the Jeong group mentions that the template flexibility possibly aids to alleviate some of the steric-induced elastic stress on particles in a closely packed structure.

To improve the quality of the dry rubbing method, we made use of an idea mentioned in the above mentioned study of Izadi et al., who proposed to use patterned instead of flat PDMS sheets for the dry removal of contaminating particles during microfabrication processes. They showed that the use of an elastomer cleaning tool which is patterned with pillars or ridges can effectively remove particles without damage to the underlying surface. The main advantage of the patterned surface is that the attracted particles get transported away from the contact interface, along the sidewalls of the patterned structures. This prevents the removed particles to re-contaminate the substrate. Inspired by this work, we investigated whether the use of a patterned rubbing tool would lead to higher quality rubbing assembly results than obtained with flat rubbing surfaces. For this purpose, patterned PDMS sheets marked by either rectangular bars or a pillar array geometry have been tested. The key idea behind the use of the patterned PDMS sheet is that this approach would allow to combine the particle assembly as well as the removal of the excess particles in a single step. However, the results obtained with a patterned PDMS rubbing tool are in case of dry assembly rather poor, with FR's not higher than 20%. Inspecting the patterned PDMS rubbing tools after rubbing revealed that the upper parts of the patterned structures, i.e., the parts that came in direct contact with the pocket substrate, were covered by partial monolayers, while the regions in between the ridges are fully loaded with silica particles. These particles are no longer available to fill the pockets on the silicon substrate. The patterning of the PDMS rubbing tool also led to a distortion of the tribological behaviour of the rubbing tool. The presence of the ridges reduces the contact area between the PDMS and the silicon and prevents the formation of a lubrication layer covering the entire surface. This appears to hinder the movement of the particles, which no longer move swiftly over the silicon wafer surface and remain very close to the point where they first made contact with the patterned rubbing tool, making less particles available for the assembly.

Collectively, these results show that dry assembly performed with either a patterned or non-patterned PDMS sheet gives poor results. Typical FR values after a first rubbing procedure are in a wide range between 50 and 90% (depending on the geometry of the pocket array) and the typical percentage of misplaced particles is on the order of 20-30%. Repeating the rubbing process increases the FR, but at the same time also leads to an increase of the number of excess particles (either present as a second layer of particles resting on top of the particles inside the pockets or next to them (see green circles in FIG. 11B). In addition, it also increases the contamination by PDMS debris detaching from the rubbing tool during the rubbing (see blue circles in FIG. 11B). Finally, the dry method preferably has a vast overload of powder particles (excess ratio 100:1), rendering this a very inefficient process. Next to that, the dry rubbing motion increases the probability for particles to break (see red circles in FIG. 11B).

Given the observed limitations of the dry processes and considering that the strong interaction forces, e.g., the capillary forces, van der Waals forces, and the tribocharging-induced electrostatic forces can be alleviated under wet conditions, we moved to testing the pocket and groove-filling process under wet conditions. One advantage of the wet method is that the solvent separates the particles from each other by the presence of a solvation shell around the particles (further discussed below). In addition, the van der Waals force is reduced, and concomitantly the electrostatic force reduces, as the solvent will allow for an easy and fast dissipation of rubbing-induced tribocharges on the particle's surface. A particular advantage for the present purposes is that the solvent lubricates the surface of both the silicon substrate and the particles, thus significantly reducing the friction force between the particles and the two substrates. Especially for the case of the pockets, less force may be needed to push the particles inside the pockets due to the lubrication layer and the risk, of the particles getting stuck halfway inside the pocket by capillary or other forces, is diminished by the presence of this liquid layer. Consequently, the particles can move more freely over the rubbing substrate than in a dry state, thus minimizing the risk of particle breakage or damage to the silicon support structure.

All wet assembly experiments started by supplying the particles through a liquid suspension on the (patterned) substrate (FIG. 10B), followed by a short evaporation time before initiation of the rubbing motion. Using wet rubbing (FIG. 6A-D), the filling ratio observed for the silica particles after a single wet rubbing experiment was in most cases nearly perfect and consistently reached 99% or higher combined with ER below 1% (FIG. 12A-C), which is in strong contrast with the dry process where the filling ratio obtained after one rubbing iteration was approximately 20%. To ensure the observed high filling ratios are not the result of an evaporation-driven assembly process and that the rubbing motion is essential, a single drop of particle suspension was supplied to the silicon substrate and left to dry without rubbing. Inspection with SEM revealed that some pockets were filled with particles, although not nearly as much as for the case where the silicon substrate was rubbed with the PDMS tool. The results show that the rubbing motion indeed aids the particle assembly into the micro-pocket array. The wet rubbing process also differs from the dry process in the way the particles are supplied to the substrate. In the wet assembly process, the particles are supplied by transferring a small volume (30-100µl) of suspended particles with a micropipette to the pocket regions of the substrate. Under wet conditions, considerably fewer particles may need to be supplied than under dry conditions, where a high excess may be needed for lubrication purposes. By controlling the concentration, the number of particles supplied to the silicon substrate was typically around 4 to 10 million, corresponding to an excess ratio of 3:1 to 9:1, i.e., considerably less than in the dry method (100:1). Furthermore, the micropipette-dispensed particles are more evenly distributed at the start of the rubbing process. Additionally, as the solvent strongly promotes the break-up of the agglomerates, considerably less rubbing force may be needed compared to the dry rubbing process where the agglomerates may first need to be separated into single particles to be able to position themselves in the pockets on silicon substrate. It is also easier to maintain the smaller rubbing force uniform over the entire silicon wafer, leading to a much more evenly distributed assembly quality. A closer inspection of the used patterned PDMS rubbing sheet reveals that the rubbing tool looks quite different after a wet rubbing process (cfr. FIG. 13B for a SEM image taken after a wet rubbing process) than a dry rubbing process (cfr. FIG. 13A for a SEM image taken after a dry rubbing process) as there are noticeably fewer particles present and in monolayer formation. The straightforward explanation for this observation is the fact that considerably fewer particles were supplied under wet conditions. As the PDMS tool is no longer overloaded with particles, the number of excess particles that were deposited on unwanted locations decreased significantly. The PDMS tools that were patterned with circular pillars did not yield adequate results as often the substrate was left with stripes of particles, a direct consequence of the fact that the pillar pattern does not have enough vertical surface area that can lead the excess particles away from the silicon wafer.

Subsequently, several parameters of the wet rubbing process were varied to find the optimal conditions. It is possible that, for other geometries than those presently studied, the optimal parameters might slightly differ from what is discussed here, but in general we have found that the selected conditions work for a variety of patterns and particles.

Since the success of the wet assembly technique depends highly on solvent parameters such as the evaporation rate and polarity of the solvent, several solvents were tested.

Especially polar solvents with a high evaporation rate like ethanol and isopropanol seem to be very suitable for the wet assembly procedure. It is noted that ethanol yields a more uniform filling over large-scale areas when compared to isopropanol, most likely because of the very high evaporation rate of isopropanol. Acetone was dismissed as this is well-known for leaving traces upon evaporation. Other solvents with a reasonably low vapour pressure, e.g. 1-hexanol and water, were found to be less suitable. The solvent used preferably have a weak to very polar character to facilitate the suspension for polar particles in a solvent, such as silica or sulfonated polystyrene particles.

Due to the polar nature of the solvent molecules, they can position themselves in a stabilizing configuration around the particles, forming what is referred to as a solvation sheath or shell. This solvation shell will stabilize single particles to stay in suspension by electrostatic repulsion (cf. the DLVO-theory) and prevent the formation of aggregates by creating a distance between the particles. Further, we noticed that it is desirable that the solvent evaporates quickly enough as we want the final state to be dry. On the other hand, the evaporation rate is preferably not too fast as this may leave the experimenter with insufficient time to ensure an adequately uniform rubbing motion over the entire silicon substrate. As the solvation of the particles weakens and eventually vanishes upon solvent evaporation, the particles become more likely to stick to the PDMS rubbing substrate than they are to enter the pockets.

Experiments were also performed to assess the effect of the particle suspension concentration as well as of the timing of the different steps of the wet rubbing process. In previous experiments, the particle suspensions were allowed to settle for approximately a minute before rubbing. This appeared to be highly critical, because the obtained filling ratios did not reach higher values than 40% without allowing for this waiting time, i.e., when the rubbing motion was initiated immediately after depositing the suspension in ethanol. This was probably because the particles inside the deposited drop did not get the chance to sediment to the bottom of the liquid layer, i.e., towards the patterned silicon substrate. When starting the rubbing motion immediately, most of the particles in the suspension get swept off to the sides of the silicon substrate without having had a chance to come in contact with the silicon substrate. By using Stokes' Law, the time it takes for 10 µm silica particles to sediment to the bottom of a 40 µl droplet on a 1×1 cm2 sample was calculated to be around 40 seconds. Thus, it can be concluded that waiting times of approximately one minute allow ample time for sedimentation of the particles and accordingly yielded a more satisfactory filling ratio (90% and up).

It was found that the most crucial aspect of the method was keeping enough liquid present during the whole rubbing procedure. The presence of a solvation layer around the particles throughout the procedure will provide sufficient lubrication to reduce friction as well as an easier dissipation of charges consequently reducing electrostatic forces. Slightly better results were obtained for longer waiting times, up until 4 minutes in case of the presently considered silicon substrates (volume of 100 µL spread out along a sample of 0.5 × 50 mm). Much longer waiting times resulted in insufficient lubrication for rubbing as then parts of the wafer already started to dry up and particles became more prone to being picked up by the rubbing tool. For this reason, it is essential to stop the rubbing motion shortly before all the solvent has evaporated in order to achieve a high FR. This leads to the conclusion that a trade-off exists between starting the rubbing process soon enough to maintain sufficient lubrication and waiting long enough for the particles to settle towards the microgroove substrate. These observations could possibly be explained by thin film entrainment, first described when studying particle assembly by dip coating. This regime occurs at a critical withdrawal speed during the dip coating process, i.e., when the thickness of the liquid film is about the same as the particle diameter. For the present purposes, where it is attempted to deposit the particles inside the pockets or microgrooves with as little as possible particles or aggregates on top or on the side, this theory suggests that the optimal liquid film thickness can be expected to be of the same order as the particle diameter. It can be expected that, analogous to the simulations made for the dip-coating process, the particles may be forced to assemble into a structured configuration inside the liquid layer.

If the liquid layer is much thicker than the particle diameter, drag forces (and other forces that are potentially also active) can still move particles within this liquid layer on top of each other, thus risking the deposition of a second layer and/or aggregates on the substrate.

After deposition of the droplet, the concentration inside the droplet increases as evaporation occurs throughout the rubbing procedure. The influence on the particle assembly of the initial concentration of the particles suspensions was thus investigated. Different concentrations, ranging from 5 to 50 mg/ml, for the suspensions were tested (FIG. 14A-D). The best results (FR = 100%, ER ≤1%) were obtained for a 20 mg/ml concentration for a drop of 60µl, which corresponds to an excess ratio of about 3:1. For lower concentrations, filling ratios became inadequate (around 30%) and very non-uniformly distributed. In the experiments conducted at a higher concentration (50mg/ml corresponding to an excess-ratio of about 7:1), the FR obtained were 100%, but many extra particles and even aggregates were deposited on top of or next to the pockets (ER = 1-10%). The presence of these extra particles suggests that this excess ratio is too high and the patterned PDMS rubbing substrate can no longer remove all excess particles which are then left on random locations on the micro-pocket substrate. The thin film entrainment concept also provides a possible explanation for the increased number of unwanted particles present for longer evaporation times. As the solvent in the particle suspension evaporates over a certain time, some areas of the silicon substrate will start to become dry and particles or aggregates present in these areas will no longer be suspended in solvent, resulting in the deposition of unwanted particles on the silicon substrate.

We also investigated the design of the line pattern on the PDMS rubbing tool. This pattern can be viewed as a set of small parallel micro-blades, similar to a doctor blade coating set-up, albeit that here the "blades" are made from an elastomeric material. More specifically, we investigated the effect of the orientation of the ridge pattern on the PDMS tool with respect to the main directions in the microgroove arrays where the pockets are connected linearly (FIG. 15A-I). It was found that the filling occurred in a preferential direction in these geometries (FIG. 15A-F). When the ridges of the PDMS tool are oriented perpendicular or parallel to the main axis (y), i.e., direction 1, the ridges will be parallel to the pockets along the x-axis and y-axis, respectively (see FIG. 15A). The FRs achieved for this direction 1 were around 90% (FIG. 15B-C. In this scenario, where the PDMS tool is repeatedly moved in the axial direction along the whole microgroove pattern, it is plausible that, due to the elastic properties of the PDMS material, particles get easily picked up again by the PDMS tool even when these particles are already residing in a pocket. This removal of particles by the patterned PDMS tool is highly dependent on the pressure that is applied manually during rubbing, showing the importance of finding an automated, and hence more reproducible way of executing the rubbing process. This becomes imperative when (almost) all the liquid has evaporated. As long as some liquid remains present, capillary bridges can be formed between the particle and the sidewalls of the pockets, anchoring the particle in the pockets through capillary bridge formation. If all the liquid has evaporated, the particles can get picked up again by the rubbing tool. Almost instantly after contact between the PDMS rubbing tool and the deposited particle suspension on the silicon substrate, the space between the ridges on the PDMS are filled with the particle suspension by capillary action.

In the case where the ridges of the rubbing substrate are oriented parallel to the main direction of the column (see FIG. 15D), i.e., direction 2, the axial direction of the rubbing process leads to a situation wherein some regions along the main axis are in constant contact with the PDMS ridge alternated with regions in contact with the particle suspension inside the groove. FR values achieved for direction 2 were around 90% (see FIG. 15E-F). The parts of the silicon substrate that are in constant intimate contact with the ridges of the PDMS have no means of supplying extra particles to the pockets underneath, while on the other hand some regions are in constant contact with the particle suspension and excess particles will be deposited there due to evaporative behaviour of the suspension.

The 45-degrees method (FIG. 15G), i.e., direction 3, seems to provide a good balance between intimate contact of the ridges with the underlying substrate and a steady supply of particles from the suspension in the ridges to the underlying substrate to fill up the remaining empty pockets. This method gave noticeably better results (≥99% filling in nearly all cases) than for any other orientation of the ridges in the PDMS with respect to the column. (See FIG. 15H-I.)

Obviously, the fit of the pockets is preferably not too tight as slightly oversized particles can get stuck before reaching the bottom of the pockets. On the other hand, if the diameter of the pockets is too large, multiple particles can enter a single pocket, which in turn can lead to excess particles adhering to the primary trapped particle. Optimal size ranges were found to be 1.1 to 1.3 times the particle diameter for both the depth and diameter of the pockets.

To explore the influence of the pitch between the micro-machined pockets on the filling ratio obtained via rubbing, we tested several patterns where the distance between the pockets (defined here as the pitch) was varied within a range of 1.5 µm (lower limit conventional lithographic techniques) to 20 µm. These experiments were conducted to verify whether the distance along which the particles can move as a single lubrication layer along the substrates surface might influence the particle assembly. No noticeable correlation between the FR and pitch could be detected under wet as well as dry assembly conditions: all silicon substrates tested under wet conditions all had an excellent FR of 99% or higher, regardless of the pitch (FIG. 16A for dry rubbing, and 16B for wet rubbing). Under dry rubbing conditions, no significant pitch effect was observed either, as now all experiments led a low FR below 25%. Possibly there might be a pitch effect for distances smaller than 1.5 µm, but this may need an alternative sub-micron patterning technique, such as e-beam lithography to produce the pocket substrates needed to test this hypothesis. To further investigate the patterning-dependency of the proposed wet particle assembly method, a variety of patterns were tested for 10 µm silica (shown in FIG. 17) and 10 µm polystyrene particles (shown in FIG. 18). These experiments were performed wafer-scale on 4-inch wafers, yielding uniform filling ratios on a large scale with very little to no errors. For all the tested geometries, the particle assembly was nearly perfect (at least 99% filling ratio or higher) and ER remained very low (< 1%). This small number of remaining particles on unwanted locations generally causes difficulties for removal, as the particles are tightly adhered to the silicon substrate, often through capillary bridge formation or adhesion to an underlying particle. If desired for the application, the very few particles that remain on top or next to the pockets can be (partly) removed by scraping a microscope glass very slowly over the substrate. Applying a wet rubbing particle assembly followed by this simple and straightforward cleaning method, the ER ratio's could be reduced from 1 to about 0.1% and thus practically achieving an error-free method for particle assembly on patterned silicon surfaces.

In conclusions, attempting to uniformly fill micro-machined pocket arrays on silicon wafers with single particles using manual rubbing, markedly better results are obtained by working under wet conditions instead of under dry rubbing conditions. This is in contrast with similar assembly studies conducted on elastomeric substrates, where dry rubbing provides excellent results.

Another difference with these studies is that the recesses in the substrate were but a fraction of the particle diameter deep, whereas in our case the particles can completely sink into the recessed pockets. Working under wet conditions has two main advantages: firstly, the number of particles that is supplied to the substrate can be better controlled by means of particle suspensions and secondly, van der Waals forces together with electrostatic forces are greatly reduced in a liquid environment, such that the particles move much more individually instead of in larger agglomerates. The assembly quality could also be significantly enhanced by introducing a ridge pattern on the PDMS rubbing tool, as allows to combine the rubbing process with the instantaneous removal of excess particles. By optimizing the direction of the pattern on the rubbing tool with respect to that of the pattern on the silicon substrate, this wet rubbing technique delivered very good assembly results on varying patterns for both silica and polystyrene particles on a wafer-scale. Other parameters such as depth of the micro-pockets and pattern did not seem to have a noticeable impact on the obtained assembly results.

It is to be understood that although preferred embodiments, specific constructions and configurations, as well as materials, have been discussed herein for devices according to the present invention, various changes or modifications in form and detail may be made without departing from the scope of this invention. For example, any formulas given above are merely representative of procedures that may be used. Steps may be added or deleted to methods described within the scope of the present invention.

## Claims

1. A microfluidic device (1) comprising:
a fluidic inlet (14) and a fluidic outlet (16), and
a plurality of interconnected fluidic channels (31, 32) fluidically coupling the fluidic inlet (14) to the fluidic outlet (16), wherein a net nominal flow direction (4) of each of the plurality of interconnected fluidic channels (31, 32) is substantially parallel,
wherein the fluidic channels (31, 32) comprise a plurality of stationary phase particles (2),
**characterized in that**, within each fluidic channel (31, 32), neighbouring particles (2), along a local flow direction, are separated from each other by a mean distance that is at most half of a mean diameter of the particles (2).

2. The microfluidic device (1) according to claim 1, wherein the fluidic channels (31, 32) are meandering, wherein a meander ratio of the fluidic channels, in the net nominal flow direction (4), is at least 1.5.

3. The microfluidic device (1) according to any of the previous claims, wherein a horizontal plane intersects each of the plurality of fluidic channels (31, 32), wherein a mean width (Wi), perpendicular to the local flow direction, and in the horizontal plane, of each fluidic channel (31, 32) is from 1.0 to 50, for example from 1.1 to 10, times the mean diameter of the particles (2).

4. The microfluidic device (1) according to claim 3, wherein a mean height of each fluidic channel (31, 32), perpendicular to the local flow direction and perpendicular to the width, at least 1.0, and preferably at most 5000, times the mean diameter of the particles (2).

5. The microfluidic device (1) according to any of the previous claims, wherein the plurality of interconnected fluidic channels (31, 32) comprises at least 2, preferably at least 100, interconnected fluidic channels (31, 32).

6. The microfluidic device (1) according to any of the previous claims, wherein each fluidic channel (31, 32) comprises a plurality of fluidically coupled containers (35, 36, 37), wherein the containers (35, 36, 37) have a mean width of from 1.1 to 3.5 times the mean diameter of the particles (2), and wherein a distance between the centers of adjacent containers (35, 36, 37) is at most 1.5 times the width of the containers (35, 36, 37).

7. The microfluidic device (1) according to claim 6, wherein:
the containers have a width of from 1.0 to 1.9 times the mean diameter of the particles, and adjacent containers (35, 36, 37) are fluidically coupled through a coupling channel (38) having a mean width smaller than 1.0, preferably from 0.0.3 to 0.0.8, times the mean particle diameter; or
the containers have a width of from 2.0 to 2.9 times the mean diameter of the particles, and adjacent containers (35, 36, 37) are fluidically coupled through a coupling channel (38) having a mean width of from 0.3 to 1.4 times the mean particle diameter; or
the containers have a width of from 3.0 to 3.9 times the mean diameter of the particles, and adjacent containers (35, 36, 37) are fluidically coupled through a coupling channel (38) having a mean width of from 0.3 to 2.1 times the mean diameter of the particles.

8. The microfluidic device (1) according to any of the previous claims, wherein the inlet (14) is connected to the plurality of fluidic channels (31, 32) via a first flow distributor (13), and/or wherein the outlet (16) is connected to the plurality of fluidic channels via a second flow distributor (15),
wherein a mean channel width of the first flow distributor (13) and/or the second flow distributor (15) is from 0.5 to 2.0, preferably from 0.7 to 1.3, times a mean channel width (Wi) of the plurality of fluidic channels (31, 32).

9. A chromatography device comprising the microfluidic device (1) according to any of the previous claims.

10. Use of the microfluidic device (1) according to any of claims 1 to 8 for chromatography.

11. A method for manufacturing the microfluidic device (1) according to any of claims 1 to 8, or the microfluidic device (1) of the chromatography device according to claim 9, comprising:
obtaining a substrate (40) comprising the plurality of interconnected fluidic channels (31, 32), and
filling the interconnected fluidic channels (31, 32) with a suspension (20) comprising the plurality of stationary phase particles (2), dispersed in a fluid.

12. The method according to claim 11, wherein obtaining the plurality of interconnected fluidic channels (31, 32) comprises obtaining the fluidic channels (31, 32) such that each fluidic channel (31, 32) has an opened top (310), wherein said filling comprises rubbing the suspension (20) into the fluidic channels (31, 32) from the top using a patterned slab (5), preferably wherein the filling is performed using wet rubbing using a profiled polydimethylsiloxane (PDMS) substrate as patterned slab (5). wherein the method further comprises a step of applying a lid (6) for closing the top (310) of the fluidic channels (31, 32).

13. The method according to claim 11, wherein obtaining the plurality of interconnected fluidic channels (31, 32) comprises obtaining the plurality of fluidic channels (31, 32), such that a side of the plurality of fluidic channels (31, 32) is opened, wherein said filling comprises pumping the suspension (20), through the opened side, into each of the channels (31, 32).

14. A method for manufacturing a microfluidic device, the method comprising:
obtaining a substrate (40) with a plurality of interconnected fluidic channels (31, 32),
providing a suspension (20) comprising a plurality of stationary phase particles (2), and
filling the plurality of interconnected fluidic channels (31, 32) with the stationary phase particles (2) by wet rubbing using a patterned elastomeric substrate (5), preferably a patterned polydimethylsiloxane (PDMS) substrate.

15. A system for producing a microfluidic device, the system comprising:
means for receiving a substrate (40) comprising a plurality of interconnected fluidic channels (31, 32),
a supply system configured for providing a suspension (20) comprising a plurality of stationary phase particles (2) onto the substrate (40), and a patterned elastomeric substrate (5), preferably a patterned polydimethylsiloxane (PDMS) substrate, configured for filling the fluidic channels (31, 32) with the stationary phase particles (2) by a wet rubbing movement.
